# NEUE EUROPÄISCHE PATENTSCHRIFT

(11) **EP 1 194 886 B2**
(45) Veröffentlichungstag und Bekanntmachung des Hinweises auf die Entscheidung über den Einspruch: **08.06.2011**
(45) Hinweis auf die Patenterteilung: 24.09.2003
(21) Anmeldenummer: 00956068.1
(22) Anmeldetag: 07.07.2000
(51) Int. Cl.: G06K 19/077

(54) **CHIPKARTE MIT EINEM FLEXIBLEN CHIP**
CHIP CARD WITH A FLEXIBLE CHIP
CARTE A PUCE AVEC PUCE FLEXIBLE

(30) Priorität: 07.07.1999 DE 19931240
(43) Veröffentlichungstag der Anmeldung: 10.04.2002
(73) Patentinhaber: Infineon Technologies AG, 85579 Neubiberg (DE)
(72) Erfinder: HAMANN, Ulrich, D-85635 Höhenkirchen-Siegertsbrunn (DE); WALLSTAB, Stefan, D-81739 München (DE)
(74) Vertreter: Viering, Jentschura & Partner
(86) Internationale Anmeldenummer: PCT/DE2000/002219
(87) Internationale Veröffentlichungsnummer: WO 2001/003060

(56) Entgegenhaltungen:
- EP-A- 0 676 717
- WO-A-99/13441
- BONNOIT A ET AL: "EVALUATION DES PERFORMANCES DE CIRCUITS LOGIQUES REALISES LOGIQUES REALISES A PARTIR DE TRANSISTORS MIS ORGANIQUES PERFORMANCE EVALUATION OF LOGIC CIRCUITS USING MIS TRANSISTORS" ONDE ELECTRIQUE,FR,EDITIONS CHIRON S.A. PARIS, Bd. 74, Nr. 4, 1. Juli 1994 (1994-07-01), Seiten 18-24, XP000438846 ISSN: 0030-2430
- PATENT ABSTRACTS OF JAPAN vol. 017, no. 581 (P-1631), 21. Oktober 1993 (1993-10-21) & JP 05 166019 A (RICOH CO LTD), 2. Juli 1993 (1993-07-02)

## Beschreibung

Die vorliegende Erfindung betrifft eine verbesserte Chipkarte.

Bei herkömmlichen Chipkarten werden die Funktionen der elektronischen Schaltung auf eine Stelle konzentriert, das sogenannte Modul. Es handelt sich um ein spezielles, besonders flaches Gehäuse, das in einer Aussparung einer entsprechend vorbereiteten Kunststoffkarte eingebaut, "implantiert" wird. Für diese Module werden üblicherweise Halbleiterchips verwendet. Wegen der Bruchempfindlichkeit dieser Chips ist deren maximale Kantenlänge bei rechteckiger Form gemäß Empfehlungen der ISO auf 5 mm begrenzt. Die Fläche ist damit auf 25 mm² begrenzt. Ist der auf der Chipkarte zu integrierende Umfang der Schaltungsfunktionen so groß, daß diese Fläche nicht ausreicht (zum Beispiel Speicher, biometrische Signalverarbeitung oder dergleichen), müssen mehrere Halbleiterchips auf der Chipkarte integriert werden, was die Herstellungskosten beträchtlich erhöht. Eine Möglichkeit, die Bruchempfindlichkeit der Chips zu reduzieren, besteht darin, die Halbleitersubstrate, insbesondere Siliziumscheiben, so zu dünnen, daß sie flexibel werden. Eine andere Möglichkeit, flexible Chips aus Silizium herzustellen, besteht darin, als Halbleitersubstrat eine dünne, auf einen Isolator (zum Beispiel Saphir) abgeschiedene Siliziumschicht zu verwenden, die nach fertiggestellter Strukturierung des Chips von diesem Isolator abgehoben wird.

In der WO 99/13441 ist ein RFID-Tag beschrieben, bei dem ein mehrschichtiges flexibles Band einen flexiblen Chip mit einer elektronischen Schaltung enthält, wobei die Abmessungen des Chips in der Ebene des Bandes mit den Abmessungen des Bandes übereinstimmen.

In der EP 0 676 717 A2 ist ein dünner, widerstandsfähiger und flexibler Halbleiterchip für Smartcards beschrieben, der 0,004 bis 0,007 Zoll dick ist und in der neutralen Faser einer Smartcard angeordnet ist. Anspruch 1 ist gegen diese schnift abgegrenzt.

Aufgabe der vorliegenden Erfindung ist es, eine Chipkarte anzugeben, die bei ausreichender Bruchunempfindlichkeit eine Integration umfangreicher Logik- und Speicherfunktionen ermöglicht.

Diese Aufgabe wird mit der Chipkarte mit den Merkmalen des Anspruchs 1 gelöst. Ausgestaltungen ergeben sich aus Anspruch 2.

Die erfindungsgemäße Chipkarte umfaßt einen flexiblen Chip, der als dünne Halbleiterschicht oder Folie ausgebildet ist und in der Ebene der Chipkarte dieselben Abmessungen wie die Chipkarte aufweist. Der flexible Chip kann insbesondere eine Schicht eines mehrlagigen Schichtaufbaus der Chipkarte bilden. Der Chip kann durch eine auf Folienstärke gedünnte Halbleiterscheibe (zum Beispiel aus Silizium) gebildet sein, in der die elektronische Schaltung integriert ist, oder auch zum Beispiel eine mit einer elektronischen Schaltung versehene Kunststoffolie. Als dafür geeignete Kunststoffe kommen zum Beispiel Polymere in Frage. Derartige Kunststoffe können halbleitend ausgebildet werden, so daß darin in an sich bekannter Weise elektronische Schaltungen ausgebildet werden können. Ein derartiger flexibler Chip, insbesondere in der Ausführung mit halbleitendem Kunststoff, kann bereits die für die Chipkarte vorgesehene Dicke aufweisen. Alternativ ist es möglich, den flexiblen Chip als dünne Folie in einen mehrlagigen Schichtaufbau aus dünnen Folien einzufügen, so daß die Chipkarte durch eine Folge übereinander aufgebrachter Folien gebildet wird.
- Figur 1: zeigt ein Schema für einen mehrlagigen Schichtaufbau eines Beispiels einer erfindungsgemäßen Chipkarte.
- Figur 2: zeigt ein Ausführungsbeispiel einer erfindungsgemäßen Chipkarte in Aufsicht.

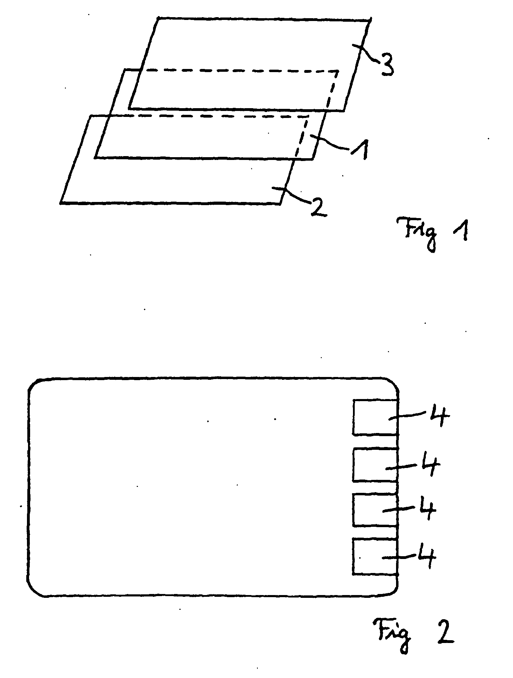

In Figur 1 ist in einer Explosionszeichnung sehr schematisch der prinzipielle Aufbau eines Beispiels einer erfindungsgemäßen Chipkarte veranschaulicht. Ein flexibler Chip 1, dessen seitliche Abmessungen mit den seitlichen Abmessungen der Chipkarte übereinstimmen, ist eingebettet zwischen einer unteren Deckfolie 2 und einer oberen Deckfolie 3, die vorzugsweise aus einem geeigneten Kunststoffmaterial gefertigt sind.

Ein geeignetes Kunststoffmaterial ist zum Beispiel ein Kunststoff, der für den Körper einer herkömmlichen Chipkarte verwendet wird. Die bezeichneten Schichten sind aufeinander laminiert und bilden zusammen eine flexible Chipkarte. Wegen der Flexibilität des Chips 1 ist die Bruchempfindlichkeit gegenüber herkömmlichen Chipkarten, bei denen eine umfangreiche Elektronik in eingesetzten Modulen konzentriert ist, erheblich reduziert. Vorzugsweise befindet sich entsprechend diesem Ausführungsbeispiel der flexible Chip 1 im Inneren einer mehrlagigen Anordnung von Folien. Ein einlagiger Aufbau, bei dem der Chip eine einzelne Schicht in der Dicke der Chipkarte bildet, ist ebenfalls möglich. Bei einem mehrlagigen Aufbau kann die Dicke der einzelnen Schichten den jeweiligen Erfordernissen angepaßt werden. Die Deckfolien können beispielsweise als reine Schutzschichten oder Isolationen sehr dünn im Vergleich zu der den Chip und damit den Hauptbestandteil der Karte bildenden Schicht sein. Alternativ können die Deckfolien vergleichsweise dick sein und den stabilisierenden Hauptbestandteil des Kartenkörpers bilden, wenn die Elektronik in einer sehr dünnen Chipfolie zwischen den Deckfolien untergebracht werden kann.

Damit der flexible Chip 1 zum Beispiel mit den Anschlüssen eines Terminals kontaktiert werden kann, können auf der Oberseite der Karte entsprechend Figur 2 Anschlußkontakte 4 angeordnet sein, die den flexiblen Chip 1 kontaktieren und in Aussparungen der darauf aufgebrachten Folie oder Folien (im Beispiel die Deckfolie 3) angeordnet sind.

Der besondere Vorteil der erfindungsgemäßen Chipkarte besteht darin, daß die Chipkarte selbst bereits, gegebenenfalls bis auf verstärkende Schichtanteile, den eigentlichen IC darstellt. Es wird also nicht ein IC gesondert in eine Chipkarte eingesetzt, sondern ein IC mit zumindest den seitlichen Abmessungen der Chipkarte verwendet.

## Patentansprüche

1. Chipkarte mit
einem flexiblen Chip (1) mit einer elektronischen Schaltung, der einen Schichtanteil der Chipkarte ausmacht,
**dadurch gekennzeichnet, dass** der Chip eine auf Folienstärke gedünnte Halbleiterscheibe, in der die elektronische Schaltung integriert ist, oder eine mit der elektronischen Schaltung versehene halbleitende Kunststofffolie ist und die Abmessungen der besagten Halbleiterscheibe beziehungsweise der besagten Kunststofffolie in der Ebene der Chipkarte mit den Abmessungen der Chipkarte übereinstimmen.

2. Chipkarte nach Anspruch 1,
die durch eine mehrschichtige Anordnung flexibler Folien gebildet ist, wovon eine den flexiblen Chip bildet.

## Claims

1. Chip card with a flexible chip (1) with an electronic circuit, which constitutes a layer component of the chip card, **characterized in that** the chip is a semiconductor wafer thinned to film thickness, in which the electronic circuit is integrated, or a semiconducting film of plastic provided with the electronic circuit, and the dimensions of the said semiconductor wafer or of the said film of plastic in the plane of the chip card coincide with the dimensions of the chip card.

2. Chip card according to claim 1, which is formed by a multi-layered arrangement of flexible films, one of which forms the flexible chip.

## Revendications

1. Carte à puce comprenant
une puce (1) souple ayant un circuit électronique, qui représente une partie de couche de la carte à puce,
**caractérisée en ce que** la puce est une tranche de semi-conducteur qui est amincie à une épaisseur de feuille et dans laquelle est intégré le circuit électronique ou une feuille de matière plastique semi-conductrice munie du circuit électronique et
les dimension de ladite tranche de semi-conducteur ou de ladite feuille de matière plastique dans le plan de la carte à puce coïncident avec les dimensions de la carte à puce.

2. Carte à puce suivant la revendication 1,
qui est formée par un agencement stratifié de feuilles souples, l'une d'entre elles formant la puce souple.
